# EUROPEAN PATENT APPLICATION

(11) **EP 2 565 877 A1**
(43) Date of publication of application: **06.03.2013**
(21) Application number: 11774658.6
(22) Date of filing: 21.01.2011
(51) Int. Cl.: G11C 19/28, G09G 3/20, G09G 3/36, G11C 19/00, H01L 21/336, H01L 29/786

(54) **SHIFT REGISTER AND DISPLAY DEVICE**

(30) Priority: 28.04.2010 JP 2010104271
(71) Applicant: Sharp Kabushiki Kaisha, Osaka-shi, Osaka 545-8522 (JP)
(72) Inventor: HORIUCHI, Satoshi, Osaka-shi Osaka 545-8522 (JP); YOSHIDA, Masahiro, Osaka-shi Osaka 545-8522 (JP); YAMADA, Takaharu, Osaka-shi Osaka 545-8522 (JP); OGASAWARA, Isao, Osaka-shi Osaka 545-8522 (JP); TANAKA, Shinya, Osaka-shi Osaka 545-8522 (JP); KIKUCHI, Tetsuo, Osaka-shi Osaka 545-8522 (JP)
(74) Representative: Müller - Hoffmann & Partner
(86) International application number: PCT/JP2011/051119
(87) International publication number: WO 2011/135873

(57) **Abstract**

A shift register stage includes a first transistor having a capacitor electrode (CAPm) that faces, in a film thickness direction, at least one of source and drain electrodes (Tr4s and Tr4d) of the first transistor in a side opposite to a gate electrode (Tr4g) of the first transistor. One of (i) the capacitor electrode (CAPm) and (ii) the one of the source and drain electrodes (Tr4s and Tr4d) which faces the capacitor electrode (CAPm), is electrically connected to a control electrode of an output transistor of the shift register stage.

## Description

### Technical Field

The present invention relates to a circuit pattern layout of a shift register for use in, for example, a gate driver of a display panel.

### Background Art

In recent years, a gate driver is monolithically formed on a liquid crystal panel by use of amorphous silicon, in order to reduce cost. Monolithically forming a gate driver is also referred to as, e.g. gate driverless, a panel including a gate driver, or gate-in-panel.

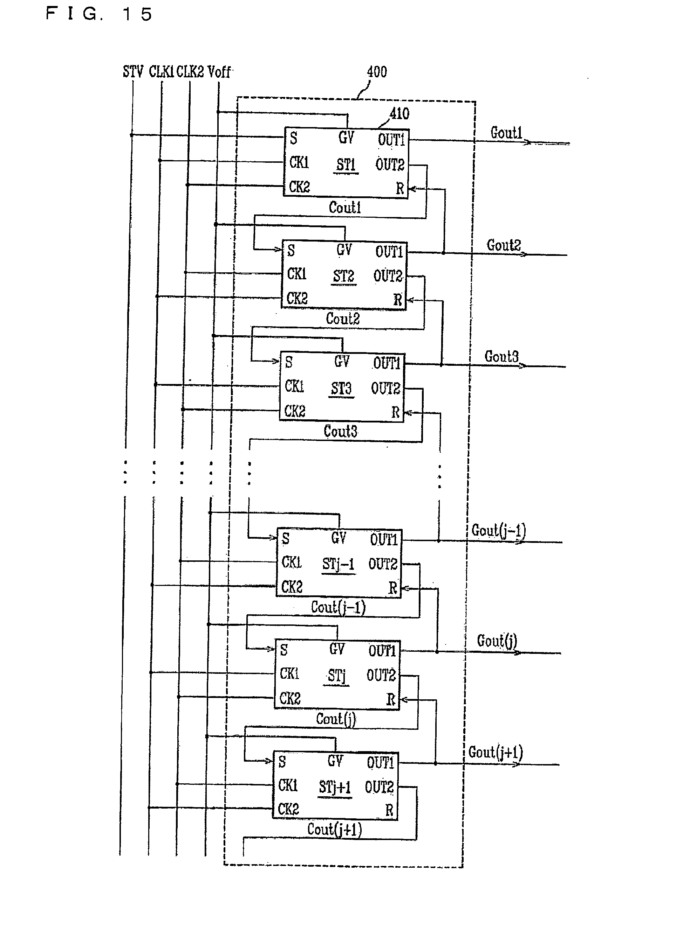

Fig. 15 is a block diagram illustrating a gate driving section 400 formed by a technique of monolithically forming a gate driver, which technique is disclosed in Patent Literature 1.

The gate driving section 400 is made up of a plurality of stages 410 which are connected in cascade and connected to respective gate lines. A stage 410 has a set terminal S, a gate voltage terminal GV, a pair of clock terminals CK1 and CK2, a reset terminal R, a gate output terminal OUT 1, and a carry output terminal OUT2.

A set terminal S of a stage 410, for example, the j-th stage STj receives a carry output signal, that is, a carry output signal Cout(j-1) from a stage STj-1. A reset terminal R of the j-th stage STj receives a gate output signal from a stage STj+1, that is, a gate output signal Gout(j+1) of the stage Stj+1. Clock terminals CK1 and CK2 of the j-th stage STj receive clock signals CLK1 and CLK2, respectively. A gate voltage terminal GV of the j-th stage STj receives a gate off voltage Voff. Note that a set terminal S of the first stage STj receives a scanning start signal STV. A gate output terminal OUT1 of the j-th stage STj outputs a gate output signal Gout(j), and a carry output terminal OUT2 of the j-th stage STj outputs a carry output signal Cout(j).

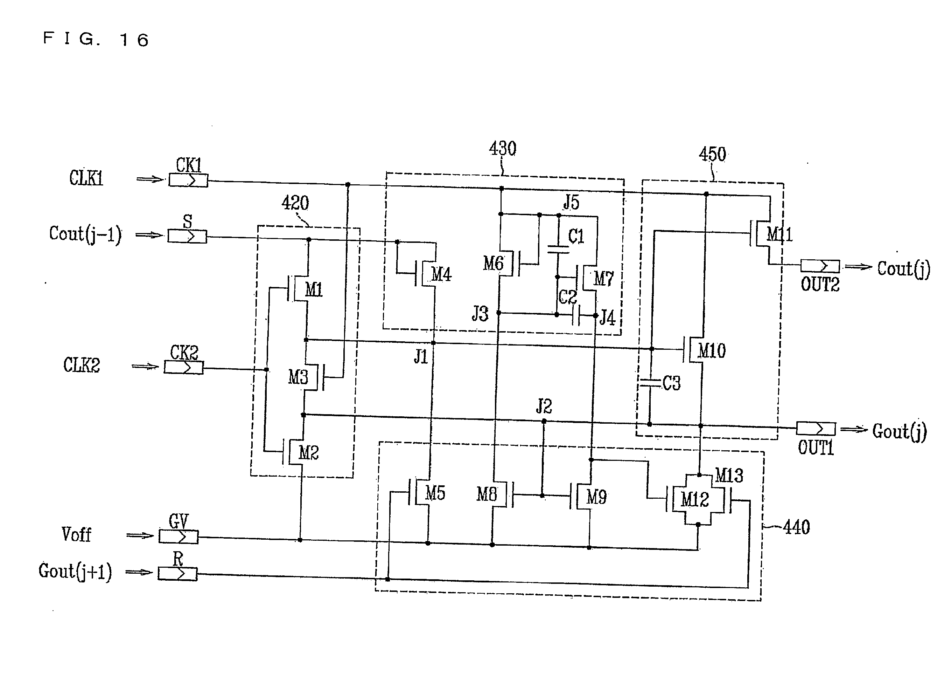

Fig. 16 illustrates a configuration of a stage 410.

The stage 410 includes an input section 420, a pull-up driving section 430, a pull-down driving section 440, and an output section 450.

The following description will briefly discuss an operation of the stage 410. A transistor M4 of the pull-up driving section 430 is turned on when a carry output signal Cout(j-1) of the stage STj-1 becomes High. This causes a capacitor C3 to be charged, whereby a connection J1 becomes High. In this case, transistors M 10 and M11 of the output section 450 are turned on. Meanwhile, an electric potential of the connection J1 is increased via the capacitor C3 that is a bootstrap capacitor in response to a clock signal CLK1 of High. Therefore, a gate output signal Gout(j) and a carry output signal Cout(j), which are sufficiently High, are outputted. When a gate output signal Gout(j+1) of the stage STj+1 becomes High, transistors M5 and M13 are turned on, and the connection J1 and a connection J2 are reset to Low.

Other components of the input section 420, the pull-up driving section 430, and the pull-down driving section 440 are circuits for properly keeping the connections J1 and J2 High or Low.

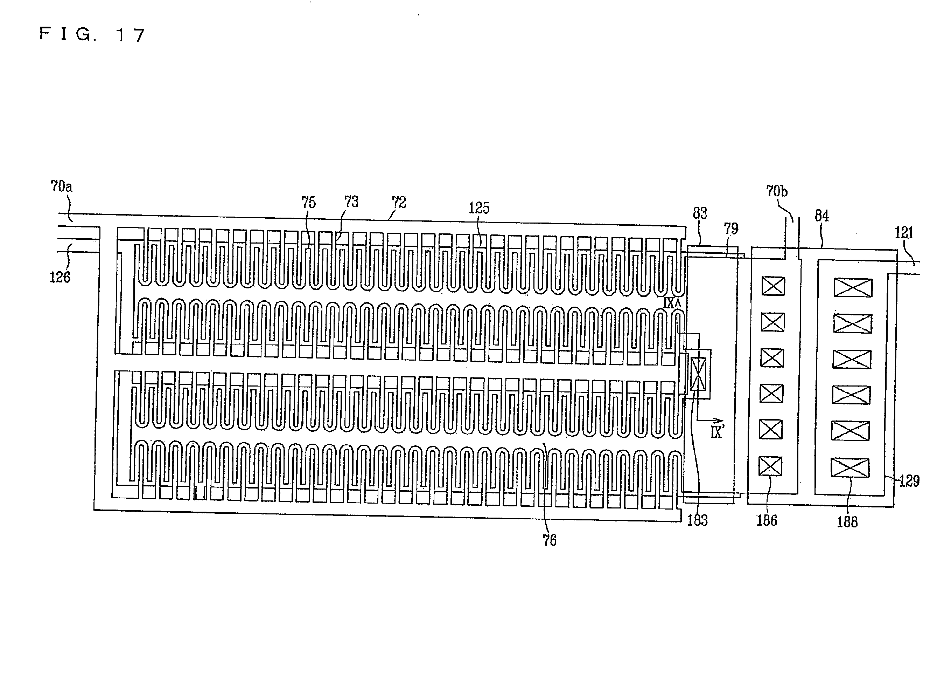

Fig. 17 illustrates a pattern layout of the transistor M10. The transistor M10 is a transistor for outputting a gate output signal Gout(j). Therefore, the transistor M10 requires a wide gate width (channel width). In order to have such a wide gate width, the transistor M10 includes an input electrode 73 and an output electrode 75 which make a pair of drain and source electrodes each having a comb-teeth shape, which pair of electrodes engage with each other.

The input electrode 73 having the comb-teeth shape is connected to an input signal line connecting section 72. The input signal line connecting section 72 is connected to an input signal line 70a. The output electrode 75 having the comb-teeth shape is connected to an output signal line connecting section 76. The output signal line connecting section 76 is connected to an output electrode expanding section 79.

A control electrode 125, which is a gate electrode, and the output electrode expanding section 79 are arranged so as to face each other in a film thickness direction, so that the capacitor C3 is formed by a gate and a source of the transistor M10. An auxiliary electrode 83 is arranged so as to sandwich the output electrode expanding section 79 with the control electrode 125 in the film thickness direction. The control electrode 125 is connected to the auxiliary electrode 83 via a contact hole 183.

The output electrode expanding section 79 is connected to a connection support member 84 via contact holes 186. The connection support member 84 is connected to an output signal line 70b. The connection support member 84 is also connected to a connection section 129 via contact holes 188. The connection section 129 is connected to a gate line 121.

### Citation List

### Patent Literature

Patent Literature 1
   Japanese Patent Application Publication Tokukai No. 2005-352455 A (Publication Date: December 22, 2005)
Patent Literature 2
   Japanese Patent Application Publication Tokukaihei No. 11-190857 A (Publication Date: July 13, 1999)

### Summary of Invention

### Technical Problem

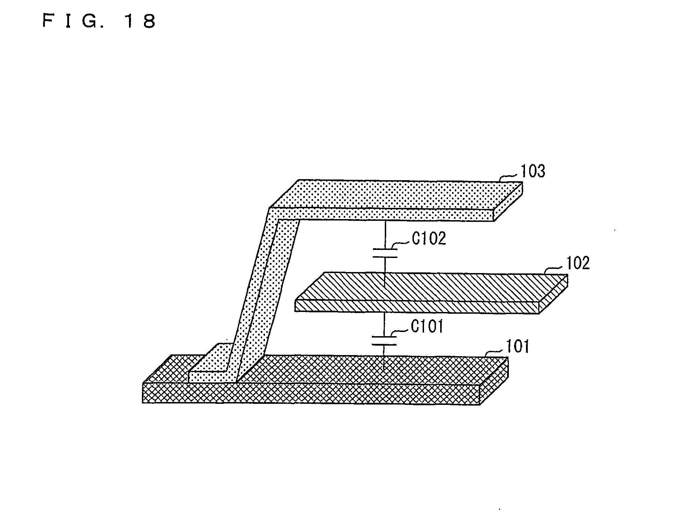

A capacitor C3 of Patent Literature 1 is formed by accumulating a control electrode 125, an output electrode expanding section 79, and an auxiliary electrode 83 in a film thickness direction via insulating films in a region adjacent to a region of a transistor M 10 that is an output transistor, as early described with reference to Fig. 17. A bootstrap capacitor corresponding to the capacitor C3 is formed by a capacitor C101 and a capacitor C102 which are connected in juxtaposition with each other (see Fig. 18). The capacitor C101 is formed by a source metal 102 corresponding to the output electrode expanding section 79 and a gate metal 101 corresponding to the control electrode 125, which face each other in a film thickness direction. The capacitor C102 is formed by the source metal 102 and a pixel electrode layer 103 corresponding to the auxiliary electrode 83, which face each other in the film thickness direction.

Note that the output transistor has a remarkably wide gate width, and therefore has a remarkably large element size. This causes the capacitor C3 serving as the bootstrap capacitor to have a large element surface area accordingly. Therefore, a display panel, in which the capacitor having such a large surface area is provided adjacent to the output transistor having such a large surface area, has an increased frame surface area.

A shift register thus formed by a conventional gate monolithic technique has a problem that increase in surface area of the bootstrap capacitor to be connected to the output transistor causes a display panel to have an increased frame surface area. Alternatively, a sufficient bootstrap capacitor cannot be formed. This makes it impossible to stably drive a shift register stage.

The present invention was made in view of the conventional problems, and an object of the present invention is to provide (i) a shift register in which a surface area of a capacitor to be connected to a transistor of a shift register stage is reduced, and (ii) a display device including the shift register.

### Solution to Problem

In order to attain the object, a shift register of the present invention is configured to be a shift register provided on a substrate, including: a plurality of shift register stages which are connected in cascade, each of the plurality of shift register stages including a first transistor having a capacitor electrode that faces, in a film thickness direction, at least one of source and drain electrodes in a side opposite to a gate electrode, one of (i) the capacitor electrode and (ii) one of the source and drain electrodes which faces the capacitor electrode, being electrically connected to a control electrode of an output transistor of the each of the plurality of shift register stages.

According to the present invention, in a case where a capacitor is formed for at least the one of the source and drain electrodes of the first transistor, it is not necessary to separately secure a region, where the capacitor is to be formed, away from an active region of a transistor in an in-plane direction of a panel, unlike a conventional configuration. The capacitor can be added in a region that substantially faces the active region in the film thickness direction. Therefore, a frame region can be made small. It is thus possible to provide a shift register in which a surface area of a capacitor to be connected to a transistor of a shift register stage is reduced.

The following effect can be brought about in a case where the first transistor is the output transistor of the shift register stage. That is, a sufficient bootstrap capacitor can be formed, and the shift register stage can be stably driven. Further, in a case where a capacitor, such as a bootstrap capacitor, is added by the gate electrode of the first transistor and at least one of the source and drain electrodes of the first transistor, it is not necessary to separately secure a region, where the capacitor is to be formed, away from an active region of a transistor in an in-plane direction of a panel from, unlike the conventional configuration. The capacitor can be added in a region that substantially faces the active region in the film thickness direction.

In order to attain the object, a shift register of the present invention is configured to be a shift register provided on a substrate, including: a plurality of shift register stages which are connected in cascade, each of the plurality of shift register stages including a first transistor, the first transistor being provided so that a first line and a second line face each other in a film thickness direction, one of a gate electrode, a source electrode, and a drain electrode of the first transistor being connected to a first element via the first line, another one of the gate electrode, the source electrode, and the drain electrode of the first transistor being connected to a second element which is different from the first element, a first metal layer being employed as the first line, and a second metal layer, which is different from the first metal layer, being employed as the second line.

According to the present invention, it is possible to add a capacitor to the first transistor by arranging existing different line regions so as to face each other.

This allows a capacitor to be added to the first transistor by use of existing line regions, in a case where the capacitor is formed by arbitrary electrodes of the first transistor. In this configuration, it is not necessary to separately secure a region, where the capacitor is to be formed, away from an active region of a transistor in an in-plane direction of a panel, unlike a conventional configuration. It is therefore possible to make small a frame region.

It is thus possible to provide a shift register in which a surface area of a capacitor to be connected to a transistor of a shift register stage is reduced.

In a case where the first transistor is the output transistor of the shift register stage, it is possible to form a sufficient bootstrap capacitor, and to stably drive the shift register stage.

It is further possible to employ a metal layer of lines, as they are, in order to add a capacitor. This makes it possible to form a pattern by use of a photomask for use in processing of the metal layer. As such, a process is not complicated, and it is not necessary to separately add a material for capacitor electrodes.

In order to attain the object, a shift register of the present invention is configured to be a shift register provided on a substrate, including: a plurality of shift register stages which are connected in cascade, a third line formed by use of a source and drain metal layer being electrically connected to a control electrode of an output transistor of a corresponding one of the plurality of shift register stages, the third line being arranged between a gate metal layer and a first electrode which is connected to the gate metal layer so as to have a region that faces the gate metal layer and the first electrode in a film thickness direction.

According to the present invention, it is possible to add capacitors between the third line and the gate metal layer, and between the third line and the first electrode, respectively. The third line is thus arranged between the gate metal layer and the first electrode. Therefore, electric field noise to be propagated to the gate metal layer and the first electrode is unlikely to be propagated to the control electrode of the output transistor via the third line. This makes it possible to reduce a capacitance caused by the control electrode necessary for preventing a malfunction from occurring in the shift register stage. This causes a reduction in surface area of the shift register. Such a reduction in the surface area of the shift register makes it possible to provide a display device whose frame region is made small.

### Advantageous Effects of Invention

A shift register of the present invention is configured to be a shift register provided on a substrate, including: a plurality of shift register stages which are connected in cascade, each of the plurality of shift register stages including a first transistor having a capacitor electrode that faces, in a film thickness direction, at least one of source and drain electrodes in a side opposite to a gate electrode, one of (i) the capacitor electrode and (ii) one of the source and drain electrodes which faces the capacitor electrode, being electrically connected to a control electrode of an output transistor of the each of the plurality of shift register stages.

A shift register of the present invention is configured to be a shift register provided on a substrate, including: a plurality of shift register stages which are connected in cascade, each of the plurality of shift register stages including a first transistor, the first transistor being provided so that a first line and a second line face each other in a film thickness direction, one of a gate electrode, a source electrode, and a drain electrode of the first transistor being connected to a first element via the first line, another one of the gate electrode, the source electrode, and the drain electrode of the first transistor being connected to a second element which is different from the first element, a first metal layer being employed as the first line, and a second metal layer, which is different from the first metal layer, being employed as the second line.

A shift register of the present invention is configured to be a shift register provided on a substrate, including: a plurality of shift register stages which are connected in cascade, a third line formed by use of a source and drain metal layer being electrically connected to a control electrode of an output transistor of a corresponding one of the plurality of shift register stages, the third line being arranged between a gate metal layer and a first electrode which is connected to the gate metal layer so as to have a region that faces the gate metal layer and the first electrode in a film thickness direction.

It is thus possible to provide a shift register in which a surface area of a capacitor to be connected to a transistor of a shift register stage is reduced.

### Brief Description of Drawings

Fig. 1

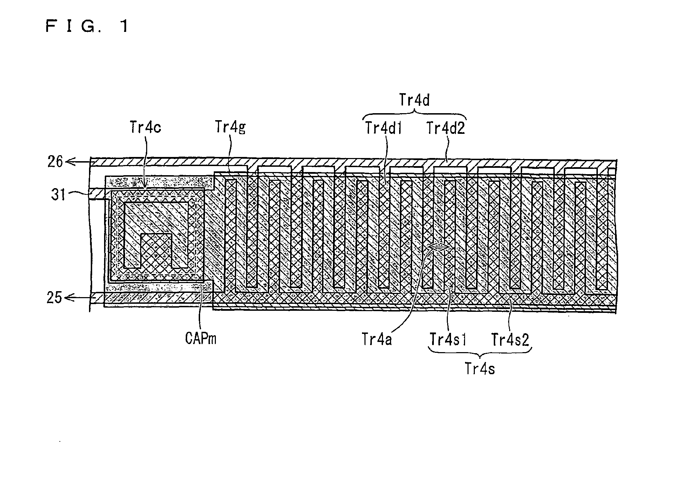

   Fig. 1 is an explanatory plain view of a pattern layout of Embodiment 1 of the present invention.
Fig. 2

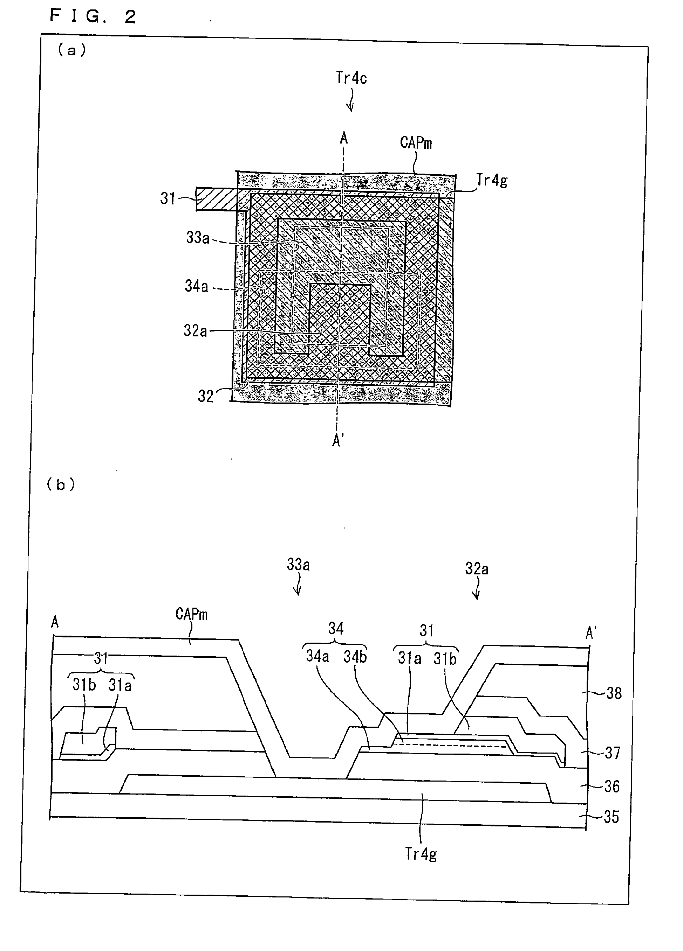

   Fig. 2 is an explanatory view of a pattern layout of a contact part of Embodiment 1. (a) of Fig. 2 is a plain view of the contact part, and (b) of Fig. 2 is a cross-sectional view taken along A-A' line.
Fig. 3

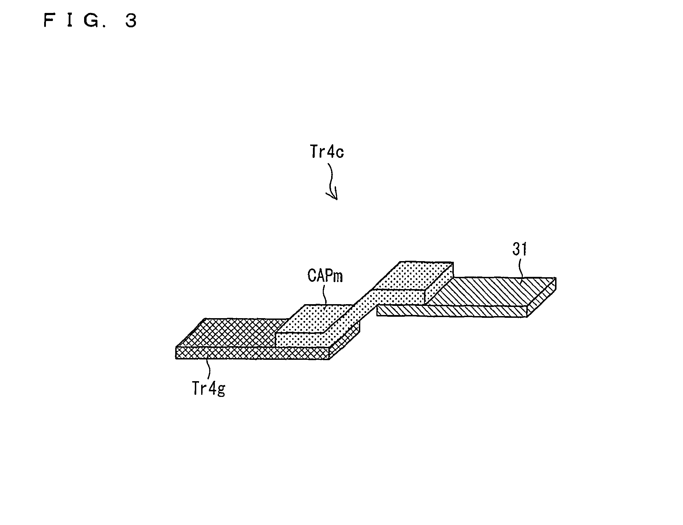

   Fig. 3 is a perspective view illustrating a connection relationship of a contact part of Embodiment 1.
Fig. 4

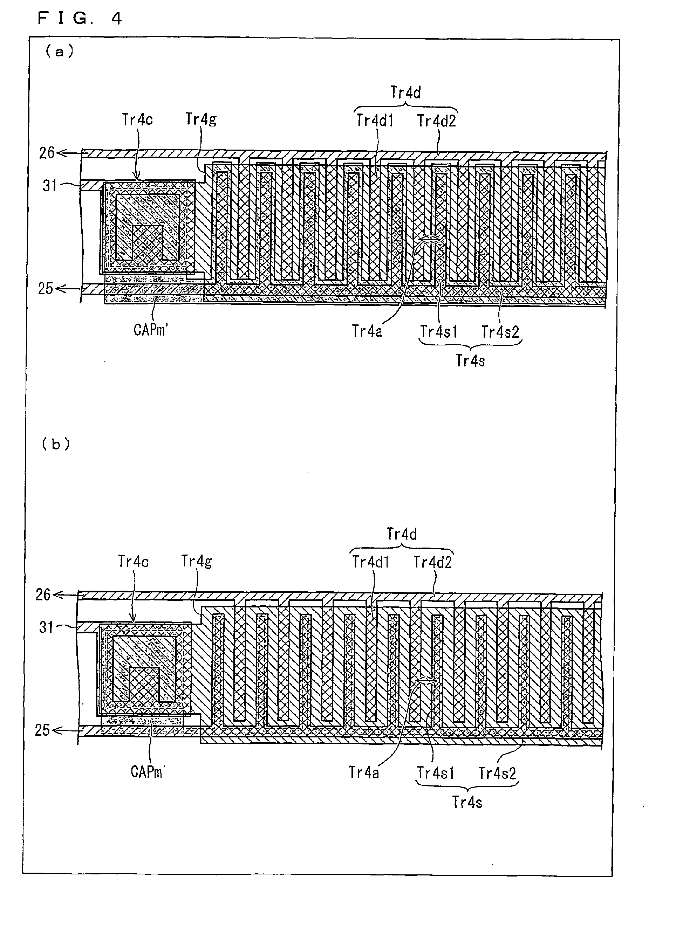

   Fig. 4 is an explanatory plain view of a pattern layout of a first modified example of Embodiment 1. (a) of Fig. 4 is a first plain view, and (b) of Fig. 4 is a second plain view.
Fig. 5

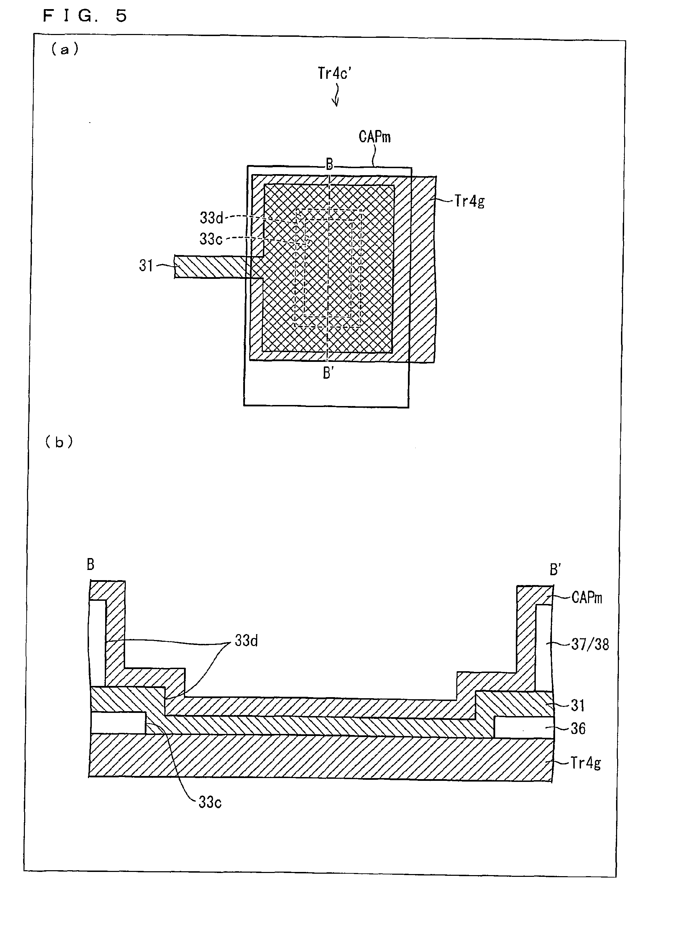

   Fig. 5 is an explanatory view of a pattern layout of a second modified example of Embodiment 1. (a) of Fig. 5 is a plain view of a contact part, and (b) of Fig. 5 is a cross-sectional view taken along B-B' line.
Fig. 6

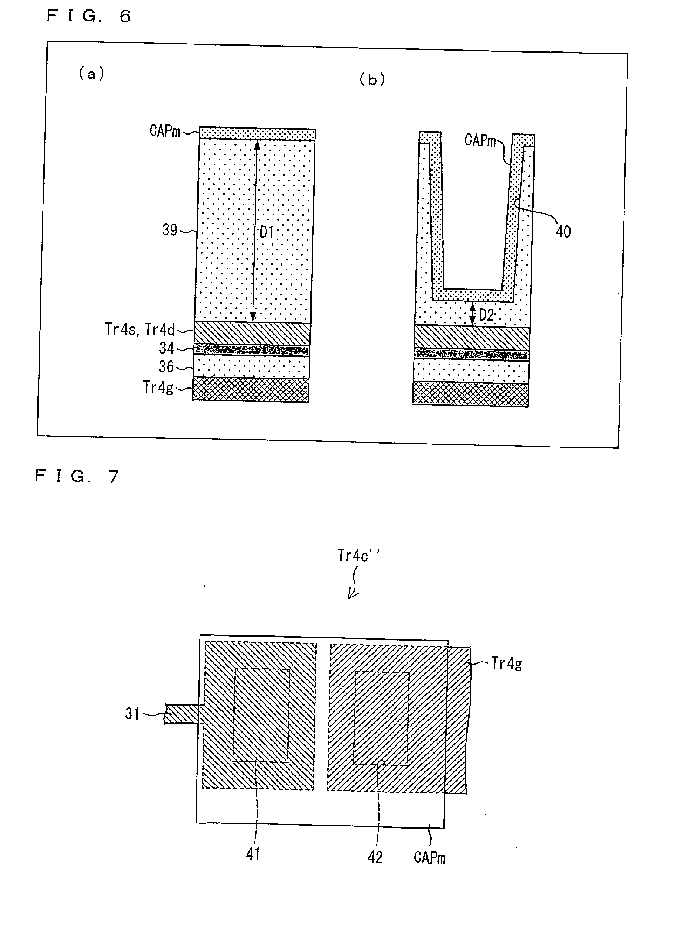

   Fig. 6 is an explanatory view of a pattern layout of a third modified example of Embodiment 1. (a) of Fig. 6 is a cross-sectional view of a capacitor including a thick insulating film. (b) of Fig. 6 is a cross-sectional view of a capacitor including a thin insulating film.
Fig. 7
   Fig. 7 is an explanatory view of a pattern layout of a contact part of a fourth modified example of Embodiment 1.
Fig. 8

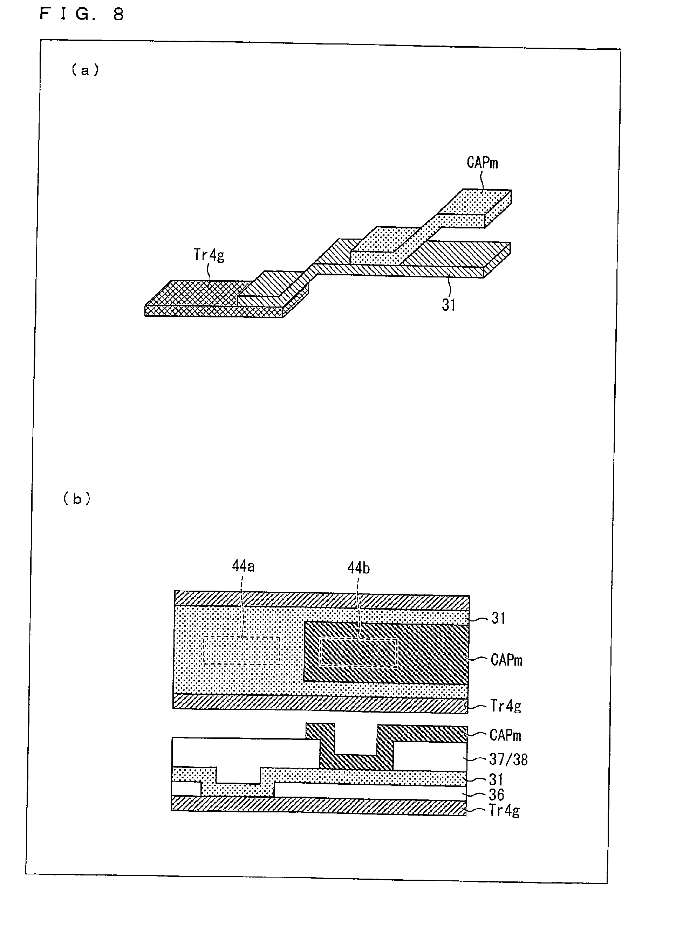

   Fig. 8 is a view illustrating a connection relationship of a contact part of a fifth modified example of Embodiment 1. (a) of Fig. 8 is a perspective view of the contact part, and (b) of Fig. 8 is a plain view and a cross-sectional view of the contact part.
Fig. 9

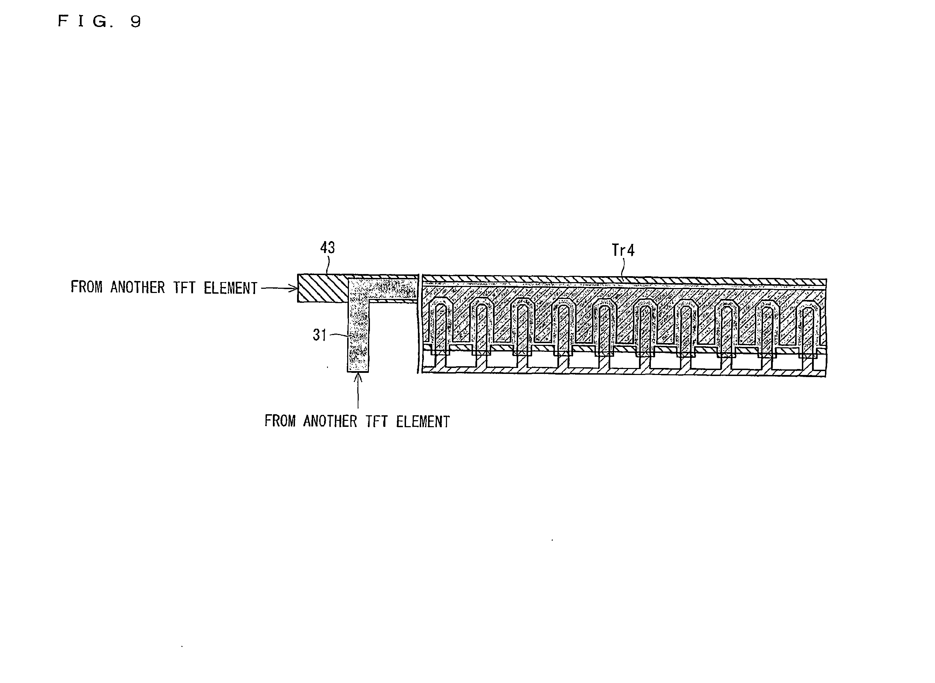

   Fig. 9 is an explanatory plain view of a pattern layout of Embodiment 2 of the present invention.
Fig. 10

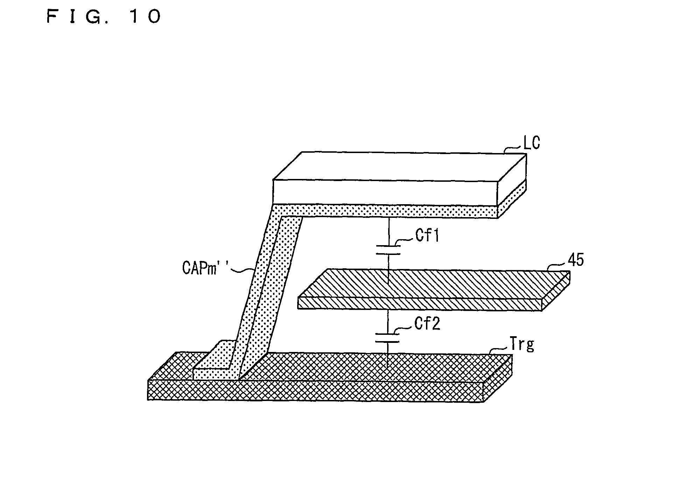

   Fig. 10 is an explanatory perspective view of a part of a pattern layout of Embodiment 3 of the present invention.
Fig. 11

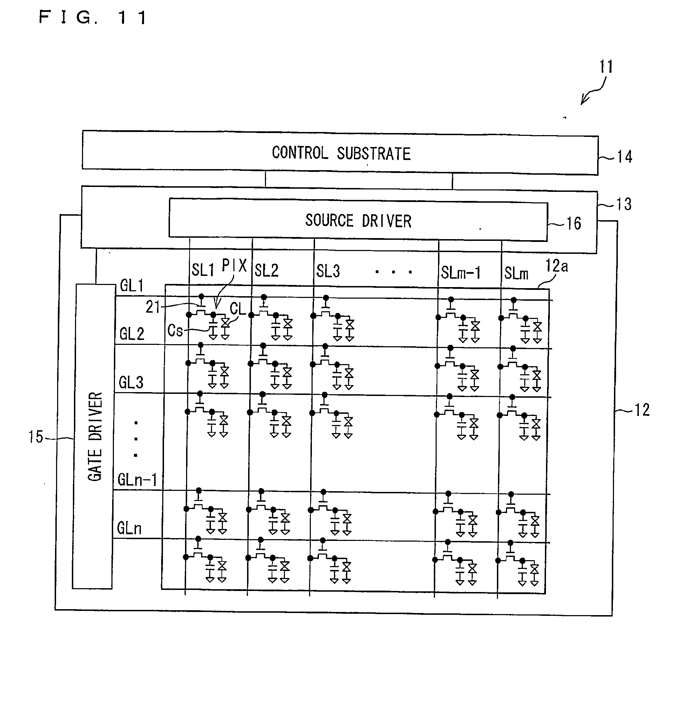

   Fig. 11 is a block diagram illustrating a configuration of a display device in accordance of an embodiment of the present invention.
Fig. 12

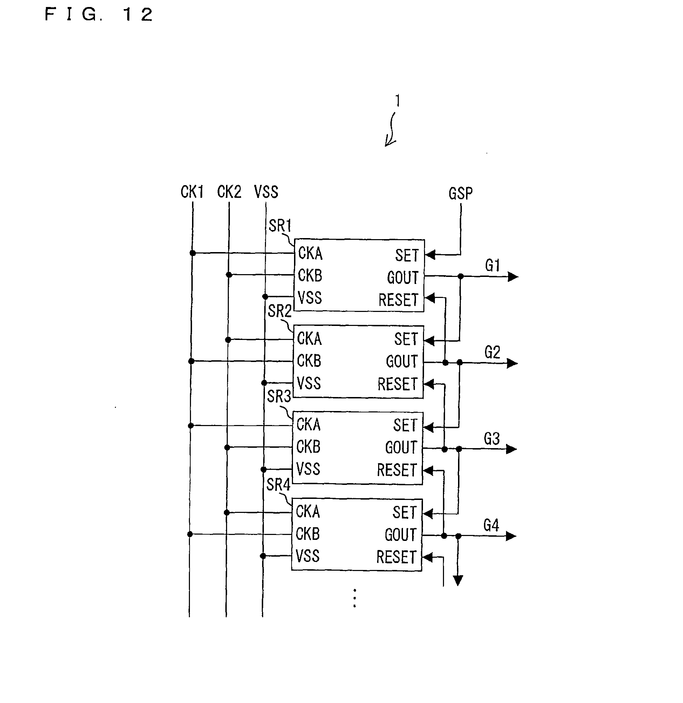

   Fig. 12 is a block diagram illustrating a configuration of a shift register to be provided in the display device illustrated in Fig. 11.
Fig. 13

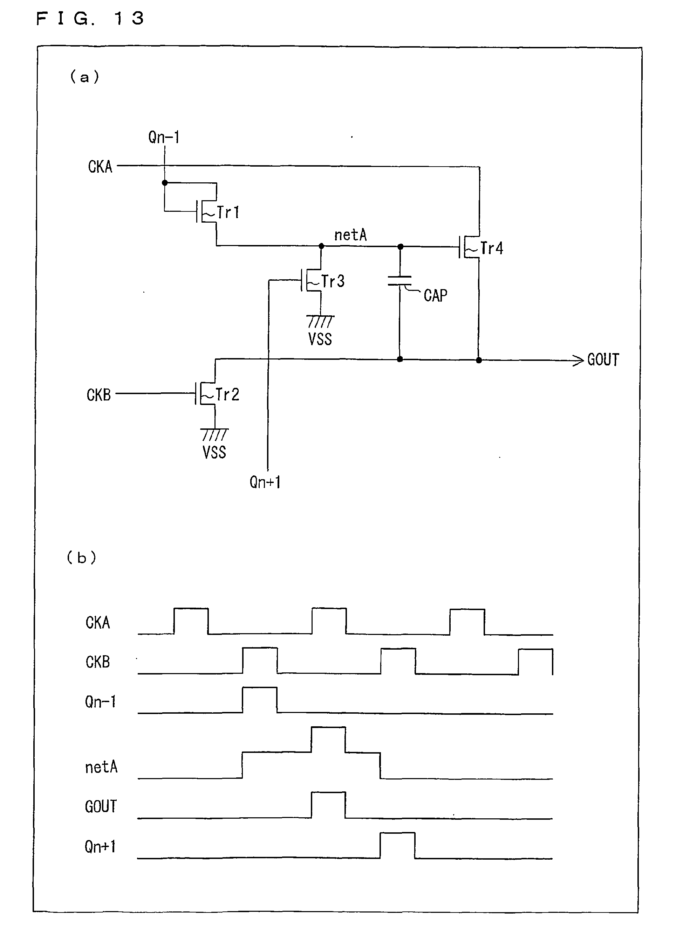

   Fig. 13 is an explanatory view of a shift register stage of the shift register illustrated in Fig. 12. (a) of Fig. 13 is a circuit diagram of the shift register stage, and (b) of Fig. 13 is a timing chart that explains an operation of the shift register stage.
Fig. 14

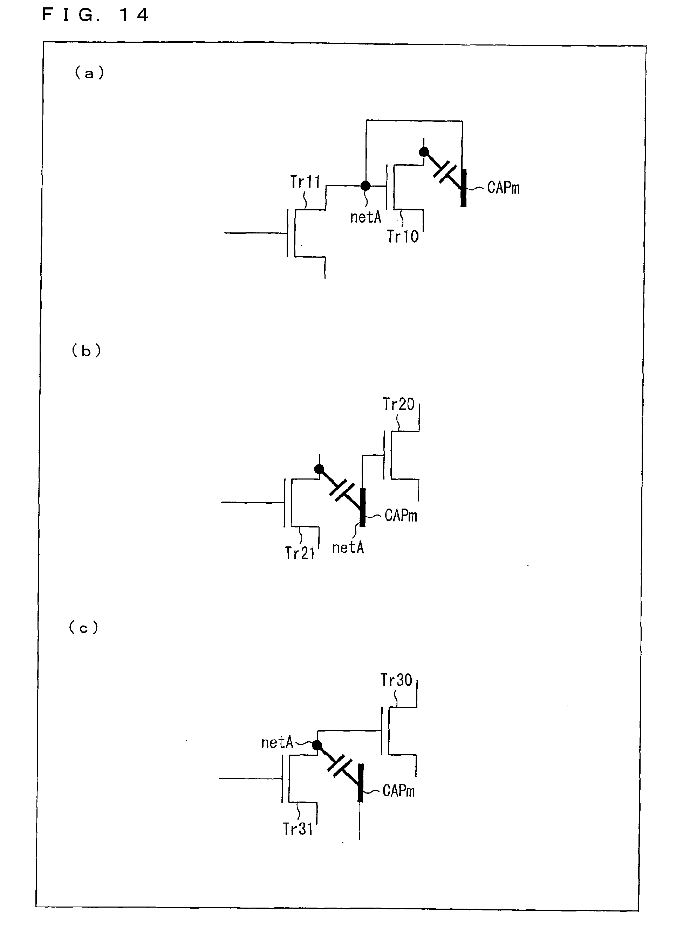

   Fig. 14 is an explanatory view of a first transistor in accordance with an embodiment of the present invention. (a) of Fig. 14 is a circuit diagram illustrating an example in which the first transistor is an output transistor. (b) of Fig. 14 is a circuit diagram illustrating a first example in which the first transistor is a transistor other than the output transistor. (c) of Fig, 14 is a circuit diagram illustrating a second example in which the first transistor is a transistor other than the output transistor.
Fig. 15
   Fig. 15 is a block diagram illustrating a conventional technique and a configuration of a shift register.
Fig. 16
   Fig. 16 is a circuit diagram illustrating a configuration of a shift register stage illustrated in Fig. 15.
Fig. 17
   Fig. 17 is plain view illustrating a pattern layout of a shift register stage illustrated in Fig. 15.
Fig. 18
   Fig. 18 is a perspective view illustrating a conventional technique and a connection relationship of a part where a bootstrap capacitor is formed.

### Description of Embodiments

The following description will discuss an embodiment of the present invention with reference to Figs. 1 through 14.

Fig. 11 illustrates a configuration of a liquid crystal display device 11 that is a display device of the present embodiment.

The liquid crystal display device 11 includes a display panel 12, a flexible printed circuit board 13, and a control substrate 14.

The display panel 12 is an active matrix display panel in which (i) a display region 12a made up of TFTs made from amorphous silicon, (ii) a plurality of gate bus lines (scanning signal lines) GL, (iii) a plurality of source bus lines (data signal lines) SL, and (iv) a gate driver (scanning signal line driving circuit) 15 are provided on a glass substrate. The display panel 12 can be prepared by use of TFTs each made from, for example, polycrystalline silicon, CG silicon, micro crystalline silicon, or IGZO (In-Ga-Zn-O), instead of amorphous silicon. Examples will later describe an example suitable for a configuration in which TFTs made from amorphous silicon are employed. In the display region 12a, a plurality of picture elements PIX are arranged in a matrix manner. Each picture element PIX includes a TFT 21 that is a selection element of the picture element, a liquid crystal capacitor CL, and a storage capacitor Cs. A gate of the TFT 21 is connected to a corresponding one of the plurality of gate bus lines GL. A source of the TFT 21 is connected to a corresponding one of the plurality of source bus lines SL. The liquid crystal capacitor CL and the storage capacitor Cs are connected to a drain of the TFT 21.

Specifically, the plurality of gate bus lines GL are gate bus lines GL1, GL2, GL3, ···, and GLn. The gate bus lines GL1, GL2, GL3, ···, and GLn are connected to respective output terminals of the gate driver (scanning signal line driving circuit) 15. And, the plurality of source bus lines SL are source bus lines SL1, SL2, SL3, ···, and SLm. The source bus lines SL1, SL2, SL3, ···, and SLm are connected to respective output terminals of a source driver 16 (later described). The storage capacitor Cs of the picture element PIX is connected to a corresponding one of a plurality of storage capacitor lines (not shown), through which the storage capacitor Cs receives a storage capacitor voltage.

The gate driver 15 is provided in a region adjacent to one end side of a direction in which the plurality of gate bus lines GL extend in the display region 12a of the display panel 12. The gate driver 15 sequentially supplies a gate pulse (scanning pulse) to the plurality of gate bus lines GL. Another gate driver can be provided in a region adjacent to the other end side of the direction so as to scan gate bus lines GL other than those scanned by the gate driver 15. Alternatively, the gate driver 15 and the another gate driver can scan an identical gate bus line GL. These gate drivers and the display region 12a are provided monolithically in the display panel 12. Examples of the gate driver 15 encompass all gate drivers referred to as, for example, gate monolithic, gate driverless, a panel including a gate driver, and gate-in-panel.

The source driver 16 is provided on the flexible printed circuit board 13. The source driver 16 supplies data signals to the respective plurality of source bus lines SL. The source driver 16 and the display region 12a may be monolithically incorporated in the display panel 12. The control substrate 14 is connected to the flexible printed circuit board 13, and supplies signals and voltages necessary for the gate driver 15 and the source driver 16. The signals and the voltages to be supplied from the control substrate 14 to the gate driver 15 are also supplied, on the display panel 12, to the gate driver 15 via the flexible printed circuit board 13.

The following description will discuss a configuration of a shift register included in the gate driver 15.

Fig. 12 illustrates a configuration of a shift register 1 serving as the shift register.

The shift register 1 is made up of shift register stages SRk (k is natural number) connected in cascade. Each shift register stage SRk has a set terminal SET, an output terminal GOUT, a reset terminal RESET, a Low power source input terminal VSS, and clock input terminals CKA and CKB. The set terminal SET of the shift register stage SRk (k ≥ 2) receives, from a shift register stage SRk-1, an output signal GOUT (reference numeral of the output terminal OUT is substituted) as a shift pulse. A set terminal SET of the shift register stage SR1 receives a gate start pulse GSP as a shift pulse. The output terminal GOUT of the shift register stage SRk supplies an output signal Gk to a corresponding scanning signal line GLk. The reset terminal RESET of the shift register stage SRk receives, from a shift register stage SRk+1, an output signal GOUT as a reset pulse. A Low power source voltage VSS (reference numeral of the Low power source input terminal VSS is substituted) is supplied to the Low power source input terminal VSS of the shift register stage SRk. The Low power source voltage VSS is a lower one of two power source voltages which are supplied to the shift register stage SRk. A clock signal CK1 is supplied to one of the clock input terminals CKA and CKB. A clock signal CK2 is supplied to the other of the clock input terminals CKA and CKB. Specifically, a clock signal CK1 and a clock signal CK2 are respectively supplied to a clock input terminal CKA and a clock input terminal CKB of one of any adjacent shift register stages, whereas a clock signal CK2 and a clock signal CK1 are respectively supplied to a clock input terminal CKA and a clock input terminal CKB of the other of the any adjacent shift register stages.

The clock signals CK1 and CK2 have respective waveforms illustrated in (b) of Fig. 13 (see CKA and CKB). The clock signals CK1 and CK2 are non-overlapping clock signals whose clock pulses do not overlap each other. (b) of Fig. 13 shows example clock pulses of the clock signals CK1 and CK2. Specifically, the clock signals CK1 and CK2 have identical pulse widths and change at timings so that each clock pulse of the clock signal CK2 is located in the midst of corresponding adjacent two clock pulses of the clock signal CK1. That is, the clock signal CK1 has a waveform identical to that of the clock signal CK2, and a clock phase of the clock signal CK1 is shifted from that of the clock signal CK2 by 180°.

Fig. 12 illustrates (i) shift register stages in each of which (a) a clock signal CK1 is supplied to a clock input terminal CKA and (b) a clock signal CK2 is supplied to a clock input terminal CKB and (ii) shift register stages in each of which (c) a clock signal CK2 is supplied to a clock input terminal CKA and (d) a clock signal CK1 is supplied to a clock input terminal CKB.

(a) of Fig. 13 illustrates a circuit configuration of the shift register stage SRk.

The shift register stage SRk includes transistors Tr1, Tr2, Tr3, and Tr4, and a capacitor CAP. The transistor (first transistor) Tr4, which serves as an output transistor, is connected to the capacitor CAP serving as a bootstrap capacitor. The transistors Tr1, Tr2, Tr3, and Tr4 are all n-channel type TFTs. The first transistor, which is subjected to formation of an additional capacitor including the capacitor CAP, is not limited to the output transistor. This will be described later.

The transistor Tr1 has a gate and a drain which are connected to a set input terminal Qn-1, and has a source connected to a gate of the transistor Tr4. The transistor Tr4 has a drain connected to a clock input terminal CKA, and a source connected to an output terminal GOUT. That is, the transistor Tr4 serves as a transmission gate for passing and blocking a clock signal to be supplied to the clock input terminal CKA. The capacitor CAP is connected between the gate and the source of the transistor Tr4. One end of the capacitor CAP, which end is connected to the gate of the transistor Tr4, is hereinafter referred to as a node netA.

The transistor Tr2 has a gate connected to a clock input terminal CKB, a drain connected to the output terminal GOUT, and a source connected to a Low power source input terminal VSS. The transistor Tr3 has a gate connected to a reset input terminal Qn+1, a drain connected to the node netA, and a source connected to the Low power source input terminal VSS.

The following description will discuss an operation of the shift register stage SRk illustrated in (a) of Fig. 13, with reference to (b) of Fig. 13.

The transistor Tr1 is turned on while a shift pulse is being supplied to the set input terminal Qn-1. This causes the capacitor CAP to be charged. The shift pulse is a gate start pulse GSP1 with regard to the shift register stage SR1. A shift pulse is an output signal Gk-1 of each shift register stage SRi other than the shift register stage SR1. Charging of the capacitor CAP (i) causes an electric potential of the node netA to be increased, (ii) causes the transistor Tr4 to be turned on, and (iii) causes a clock signal CK1 or CK2 supplied from the clock input terminal CKA to appear on the source of the transistor Tr4. The electric potential of the node netA is rapidly increased by a bootstrap effect of the capacitor CAP immediately when a clock pulse is supplied to the clock input terminal CKA. The clock pulse is supplied to the output terminal GOUT of the shift register stage SRk so as to be outputted as a gate pulse of an output signal Gk.

The transistor Tr4 is turned off when the shift pulse ceases to be supplied to the set input terminal Qn-1. When a reset pulse is supplied to the reset input terminal Qn+1, the transistor Tr3 is turned on, and the node netA and the output terminal GOUT each have an electric potential of a Low power source voltage VSS so that holding of electric charges, due to the fact that the node netA and the output terminal GOUT become a floating state, is released.

The transistor Tr2 is periodically turned on in response to a clock pulse of a clock signal CK2 or CK1 supplied to the clock input terminal CKB, until another shift pulse is supplied to the set input terminal Qn-1. This causes the node netA and the output terminal GOUT to be refreshed to a Low power source electric potential. To put it another way, a gate bus line GLk is forcibly pulled down to Low.

Thus, the gate driver 15 sequentially supplies a gate pulse to the gate bus lines GL1, GL2, GL3, ···.

The following description will discuss a pattern layout of (i) the transistor Tr4 serving as an output transistor and (ii) the capacitor CAP serving as a bootstrap capacitor, in the shift register stage SRk.

Fig. 1 is a plain view of a pattern of the transistor Tr4 and the capacitor CAP, which pattern is viewed from an upper surface side (display surface side) of the display panel 12.

The transistor Tr4 includes a gate electrode Tr4g, a source electrode (first source/ drain electrode) Tr4s, and a drain electrode (second source/ drain electrode) Tr4d. The transistor Tr4 has two source/ drain electrodes, one of which is the first source/ drain electrode and the other is the second source/ drain electrode. The drain electrode can be the first source/ drain electrode, and the source electrode can be the second source/ drain electrode.

(i) The gate electrode Tr4g and (ii) the source electrode Tr4s and the drain electrode Tr4d, are stacked, like a normal bottom gate TFT, in this order from a lower side to an upper side in a case where these electrodes are viewed from the upper surface of the display panel 12. A gate insulating film, a silicon i semiconductor layer, and a silicon n⁺ semiconductor layer are stacked in this order from the lower side to the upper side between (i) the gate electrode Tr4g and (ii) the source electrode Tr4s and the drain electrode Tr4d.

The source electrode Tr4 is a comb-teeth electrode including (i) a plurality of source finger electrodes (first part) Tr4s1 that extend in parallel to each other on the display panel 12 and (ii) a source connection electrode (second part) Tr4s2 from which the plurality of source finger electrodes Tr4s1 branch off. Similarly, the drain electrode Tr4 is a comb-teeth electrode including (i) a plurality of drain finger electrodes (first part) Tr4d1 that extend in parallel to each other on the display panel 12 and (ii) a drain connection electrode (second part) Tr4d2 from which the plurality of drain finger electrodes Tr4d1 branch off.

The plurality of source finger electrodes Tr4s1 and the plurality of drain finger electrodes Tr4d1 are alternately provided on the display panel 12. A silicon i semiconductor layer region becomes an active region Tr4a which forms a channel region of the transistor Tr4. The silicon i semiconductor layer region extends (i) between any adjacent ones of the plurality of source finger electrodes Tr4s1 and the plurality of drain finger electrodes Tr4d1 and (ii) directly under the plurality of source finger electrodes Tr4s1 and the plurality of drain finger electrodes Tr4d1.

The source connection electrode Tr4s2 is connected to a connection line 25 that extends outside of the transistor Tr4. The drain connection electrode Tr4d2 is connected to a connection line 26 that extends outside of the transistor Tr4. In, for example, (a) of Fig. 13, the source connection electrode Tr4s2 is connected to a line connected to the output terminal GOUT, which line serves as the connection line 25, and the drain connection electrode Tr4d2 is connected to a line connected to the clock input terminal CKA, which line serves as the connection line 26.

The gate electrode Tr4g extends directly under the active region Tr4a. The gate electrode Tr4g does not extend so as to face the drain connection electrode Tr4d2 in a film thickness direction but extends so as to face the source connection electrode Tr4s2 in the film thickness direction. Such a configuration makes it possible to secure a capacitor formed by the gate electrode Tr4g and the source electrode Tr4s as large as possible.

The gate electrode Tr4g is electrically connected, in a contact part Tr4c, to (i) a connection line 31 connected to another element and (ii) a capacitor electrode CAPm of the capacitor CAP which capacitor electrode CAPm is one end of the capacitor CAP on a node netA side. The connection line 31 corresponds to a line connected to the node netA in (a) of Fig. 13, and is formed by a metal layer which is employed as a source electrode or a drain electrode.

A pixel electrode layer that is a transparent electrode such as ITO or IZO is employed as the capacitor electrode CAPm. The capacitor electrode CAPm extends so as to face, in the film thickness direction, the plurality of source finger electrodes Tr4s1, the source connection electrode Tr4s2, and the plurality of drain finger electrodes Tr4d1. Note, however, that the capacitor electrode CAPm does not face the drain connection electrode Tr4d2 in the film thickness direction.

(a) and (b) of Fig. 2 illustrate in detail a configuration of the contact part Tr4c. (b) of Fig. 2 is a cross-sectional view taken along A-A' line illustrated in (a) of Fig. 2.

The connection line 31, the gate electrode Tr4g, and the capacitor electrode CAPm are electrically connected to each other via a contact hole 33a which is formed in an inner region of a rectangularly annular part 32 formed by the connection line 31, in the contact part Tr4c (see (a) of Fig. 2). The contact part Tr4c can be configured by using a region where a metal layer from which the connection line 31 is formed is changed to a metal layer from which the gate electrode Tr4g of the transistor Tr4 is formed. In this case, a pixel electrode layer that is present in such a region can be employed as the capacitor electrode CAPm.

The connection line 31 has an outgoing part 32a which is drawn out from a side of the rectangularly annular part 32, which side faces the source connection electrode Tr4s2, toward the center of the inner region of the rectangularly annular part 32.

The contact part Tr4c has a configuration in which (i) a glass substrate (substrate) 35, (ii) the gate electrode Tr4g, (iii) a gate insulating film 36, (iv) a semiconductor layer 34 made up of a silicon i semiconductor layer 34a (that is a lower layer) and a silicon n⁺ semiconductor layer 34b (that is an upper layer), (v) the connection line 31 formed by use of a Ti layer 31a (that is a lower layer) and an Al layer 31b (that is an upper layer), (vi) a passivation film 37 formed by an inorganic insulating film such as SiNₓ or SiO₂, (vii) an organic insulating film 38, and (viii) the capacitor electrode CAPm are stacked in this order from below (see (b) of Fig. 2).

The contact hole 33a is formed so as to penetrate the organic insulating film 38, the passivation film 37, and the gate insulating film 36. The gate electrode Tr4g and the capacitor electrode CAPm are in contact with each other in a bottom part of the contact hole 33a. A stair-like pattern etching is performed in a region of the outgoing part 32a such that the silicon i semiconductor layer 34a, the silicon n⁺ semiconductor layer 34b, the Ti layer 31a, and the Al layer 31b are exposed in the outgoing part 32a sequentially from an edge side of the outgoing part 32a. The connection line 31 and the capacitor electrode CAPm are in contact with each other in the stair-like pattern.

The contact hole 33a can be formed by use of a photomask. More specifically, for example, a contact hole is first formed in the organic insulating film 38 by use of a photomask. The passivation film 37 and the gate insulating film 36 are then consecutively etched while using, as a mask, (i) a pattern of the contact hole of the organic insulating film 38, (ii) the connection line 31, and (iii) the semiconductor layer 34. The capacitor electrode CAPm is stacked and patterned on the contact hole 33a thus formed.

With the configuration of the contact part Tr4c, the gate electrode Tr4g is electrically connected to the connection line 31 indirectly via the capacitor electrode CAPm (see Fig. 3).

A first capacitor is thus formed by the capacitor electrode CAPm and source and drain electrodes (the plurality of source finger electrodes Tr4s1, the source connection electrode Tr4s2, and the plurality of drain finger electrodes Tr4d1). The capacitor electrode CAPm is connected to the gate metal Tr4g via the contact part Tr4c, that is, the capacitor electrode CAPm is electrically connected to the node netA that is a control electrode of the transistor Tr4. Therefore, a combined capacitance of a second capacitor and a third capacitor is substantially equal to a total capacitance of a capacitor formed by the gate of and the source of the transistor Tr4. The second capacitor is formed by the capacitor electrode CAPm of the first capacitor and the source electrode Tr4s (the plurality of source finger electrodes Tr4s1, and the source connection electrode Tr4s2). The third capacitor is formed by the gate electrode Tr4g and the source electrode Tr4s. It is assumed in the present embodiment that the second capacitor is the capacitor CAP.

The second capacitor is larger than a capacitor formed by the capacitor electrode CAPm and the plurality of drain finger electrodes Tr4d1. Therefore, a capacitor formed by the capacitor electrode CAPm and the source electrode Tr4s that is the first source/ drain electrode is larger than a capacitor formed by the capacitor electrode CAPm and the drain electrode Tr4d that is the second source/ drain electrode.

The provision of the capacitor electrode CAPm generally means provision of a capacitor electrode which faces, in a film thickness direction and on a side opposite to a side where a gate electrode is located, one of two source and drain electrodes of an output transistor of a shift register so as to additionally form a capacitor by the gate electrode and at least one of the two source and drain electrodes of the output transistor.

Alternatively, the provision of the capacitor electrode CAPm generally means that a capacitor electrode is provided with respect to at least one of two source and drain electrodes of an output transistor in a shift register, which capacitor electrode faces, in a film thickness direction and on a side opposite to a side where a gate electrode is located, one of the two source and drain electrodes of the output transistor of the shift register. That is, even in a case where, as early described, a capacitor electrode CAPm is not connected to a gate electrode of an output transistor, it is similarly possible to provide a capacitor electrode that faces a source electrode or a drain electrode in a film thickness direction.

Unlike the conventional configuration, this makes it unnecessary to separately secure a region, where a capacitor is to be formed, away from an active region of an output transistor in an in-plane direction of a panel, in a case where the capacitor is formed for at least one of source and drain electrodes of the output transistor or in a case where the capacitor is additionally formed by a gate electrode of the output transistor and at least one of the source and drain electrodes of the output transistor. Such a capacitor can be additionally formed in a region that substantially faces the active region in the film thickness direction. Therefore, a frame region can be made small. It is further possible to employ, as a capacitor electrode, a pixel electrode layer on the active region as it is, which pixel electrode layer has been conventionally removed because it is of no other uses. This makes it possible to form a pattern by use of a photomask for use in processing of a pixel electrode layer. As such, it is possible to prevent a process from being complicated, and it is not necessary to separately use a material for a capacitor electrode.

In a case where a capacitor formed by the gate electrode and the first source/ drain electrode is made larger than a capacitor formed by the gate electrode and the second source/ drain electrode, it is possible to form, in a region outside of the active region of the output transistor, a part of the capacitor formed by the gate electrode and the first source/drain electrode, like a relationship between the source connection electrode Tr4s and the capacitor electrode CAPm.

The capacitor electrode and the gate electrode can also be connected with each other through the use of a region where a metal layer serving as a connection line to be connected to the gate electrode of the output transistor is changed to a metal layer from which the gate electrode of the output transistor is formed. This makes it possible to reduce the number of line connection regions and their occupied areas. It is therefore possible to secure a large region for a driving circuit. As such, the driving circuit can be increased in size, that is, can be improved in current driving capability.

Note that, in a case where the transistor Tr4 is realized by a top gate TFT in the configuration of Fig. 1, the gate electrode Tr4g and the capacitor electrode CAPm are vertically interchanged with respect to the source electrode Tr4s and the drain electrode Tr4d.

(a) of Fig. 4 illustrates a first example configuration of a first modification of the pattern layout of the transistor Tr4 and the capacitor CAP.

According to the first example configuration of the first modification, a capacitor electrode CAPm' is configured so as not to face the plurality of drain finger electrodes Tr4d1 and the drain connection electrode Tr4d2 in the film thickness direction but so as to face the plurality of source finger electrodes Tr4s1 and the source connection electrode Tr4s2 in the film thickness direction, unlike the capacitor electrode CAPm in the pattern layout illustrated in Fig. 1. In this case, a capacitor is additionally formed just by the gate electrode Tr4g and the source electrode Tr4s. Therefore, a first capacitor formed by the capacitor electrode CAPm and a source electrode or a drain electrode is equal, in capacitance, to a second capacitor formed by the capacitor electrode CAPm and the source electrode Tr4s.

The configuration of (a) of Fig. 4 provides (i) a configuration required in a case where a capacitor is formed for one of the source and drain electrodes of the output transistor and (ii) a configuration required in a case where a capacitor is formed by the gate electrode of the output transistor and one of the source and drain electrodes of the output transistor.

According to the configuration of (a) of Fig. 4, the capacitor electrode CAPm faces a semiconductor layer provided in an active region other than a region, where the capacitor electrode CAPm faces the source electrode Tr4s and the drain electrode Tr4d of the transistor Tr4 in the film thickness direction, so as to have a region where the capacitor electrode CAPm and the semiconductor layer overlap each other. With the configuration, the capacitor electrode and the source and drain electrodes overlap each other in a large area. This makes it possible to more efficiently secure a large capacitor.

(b) of Fig. 4 illustrates a second example configuration of the first modification of the pattern layout of the transistor Tr4 and the capacitor CAP.

According to the second example configuration of the first modification, a capacitor electrode CAPm' is configured so as not to face the semiconductor layer provided in the active region other than the region, where the capacitor electrode CAPm faces the source electrode Tr4s and the drain electrode Tr4d of the transistor Tr4 in the film thickness direction, unlike the capacitor electrode CAPm of the configuration illustrated in (a) of Fig. 4. In (b) of Fig. 4, a pattern of the capacitor electrode CAPm is formed so as to be inside a pattern of the plurality of source finger electrodes Tr4s1 and the source connection electrode Tr4s2, in a case where the pattern of the capacitor electrode CAPm is viewed in the film thickness direction. With the configuration, it is possible to form a capacitor whose size changes less and which has a stable and large capacitor, even in a case where the capacitor electrode is misaligned with respect to the source and drain electrodes during production.

According to the configuration of (a) or (b) of Fig. 4, it is possible to additionally form a capacitor for a desired one of the source and drain electrodes of the output transistor.

(a) and (b) of Fig. 5 illustrate a configuration of a second modification of the pattern layout of the transistor Tr4 and the capacitor CAP. (a) of Fig. 5 is a plain view of the pattern layout, and (b) of Fig. 5 is a cross-sectional view taken along B-B' line illustrated in (a) of Fig. 5.

In the configuration of the second modification, the contact part Tr4c of the pattern layout illustrated in Fig. 1 is replaced with a contact part Tr4c'.

In the contact part Tr4c', a connection line 31 is directly connected to a gate electrode Tr4g via a center contact hole 33c, and a capacitor electrode CAPm is directly connected to the connection line 31 via a contact hole 33d formed so as to surround the center contact hole 33c (see (a) and (b) of Fig. 5).

In the configurations of (a) and (b) of Fig. 5, the capacitor electrode and the gate electrode can also be connected with each other through the use of a region where a metal layer serving as the connection line to be connected to the gate electrode of an output transistor is changed to a metal layer from which the gate electrode of the output transistor is formed. This makes it possible to reduce (i) the number of line connection regions and (ii) an occupied area of the line connection regions. Since a large region is secured for a driving circuit, it is possible to increase a size of the driving circuit, that is, it is possible to improve a current driving capability.

(a) and (b) of Fig. 6 each are an explanatory view of a configuration of a third modification of the pattern layout of the transistor Tr4 and the capacitor CAP.

According to the configuration of the third modification, a capacitor electrode CAPm is formed on an insulating film 39 after reducing a thickness of the insulating film 39 to a thickness D2 that is smaller than a thickness D1 (see (b) of Fig. 6) such that the thickness D1 of the insulating film 39 (see (a) of Fig. 6) is formed between (i) the capacitor electrode CAPm and (ii) respective of a source electrode Tr4s and a drain electrode Tr4d, unlike the capacitor electrode CAPm in the pattern layout illustrated in Fig. 1. An increase in thickness D1 causes a reduction in capacitance between (i) the capacitor electrode CAPm and (ii) respective of the source electrode Tr4s and the drain electrode Tr4d. In such a situation, a reduction of thickness D1 to D2 can remarkably bring about an effect of increasing a capacitor CAP.

For example, in a case where the insulating film 39 is the organic insulating film 38 illustrated in (b) of Fig. 2a. The thickness D1 of the organic insulating film 38 is fundamentally set to be thick so as to reduce paracitic capacitance caused by a pixel electrode and a signal line in a picture element PIX. Therefore, the thickness D1 is preferably reduced to the thickness D2 in a region where the first capacitor is formed, which region is a region at least substantially facing an active region in the film thickness direction. The insulating film 39 is made up of layers of the organic insulating film 38 and the passivation film 37 that is formed by use of an inorganic insulating film (see (b) of Fig. 2). Therefore, merely the passivation film 37 can be left in the region where the first capacitor is to be formed. Thus, the thickness of the insulating film between (i) the capacitor CAPm and (ii) respective of the source electrode Tr4s and the drain electrode Tr4d is preferably smaller than that of the insulating film between a pixel electrode layer and respective source and drain metal layers of a TFT 21 that is a selection element in a display region 12a.

Fig. 7 is an explanatory view of a configuration of a fourth modification of the pattern layout of the transistor Tr4 and the capacitor CAP.

In the fourth modification, the contact part Tr4c of the pattern layout illustrated in Fig. 1 is replaced with a contact part Tr4c".

In the contact part Tr4c", (i) a connection line 31 is connected to a capacitor electrode CAPm via a contact hole 41 and (ii) a gate electrode Tr4g is connected to the capacitor electrode CAPm via a contact hole 42 formed in a region where the contact hole 42 and the contact hole 41 do not overlap each other (see Fig. 7).

(a) and (b) of Fig. 8 each are an explanatory view of a configuration of a fifth modification of the pattern layout of the transistor Tr4 and the capacitor CAP.

In the fifth modification, the contact part Tr4c of the pattern layout illustrated in Fig. 1 is configured such that the gate electrode Tr4g is indirectly connected to the capacitor electrode CAPm via the connection line 31. (a) of Fig. 8 is a perspective view of a contact part Tr4c of the fifth modification, and (b) of Fig. 8 is a plain view and a cross-sectional view of the contact part Tr4c of the fifth modification.

In (a) of Fig. 8, the gate electrode Tr4g is changed to the connection line 31, while maintaining an electrical connection between them, in a first part of the connection line 31. A capacitor electrode CAPm is electrically connected, by contact, with the connection line 31 in a second part of the connection line 31. Note that the first part is different from the second part. The contact part Tr4c is configured so that the gate electrode Tr4g, a gate insulating film 36, the connection line 31, a passivation film 37, an organic insulating film 38, and the capacitor electrode CAPm are provided, in this order, on a glass substrate (not shown) (see (b) of Fig. 8). The connection line 31 is connected to the gate electrode Tr4g via a contact hole 44a formed in the gate insulating film 36. The capacitor electrode CAPm is connected to the connection line 31 via a contact hole 44b formed in the passivation film 37 and the organic insulating film 38. The contact hole 44a and the contact hole 44b do not overlap each other in a film thickness direction.

In the configurations of (a) and (b) of Fig. 8, the capacitor electrode and the gate electrode can be electrically connected with each other through the use of a region where a metal layer serving as a connection line to be connected to the gate electrode of the output transistor is changed to a metal layer from which the gate electrode of the output transistor is made. This makes it possible to reduce the number of line connection regions and an area occupied by the line connection regions. Such a reduction causes a large region to be secured for a driving circuit. As such, the driving circuit can be increased in size, that is, a current driving capability can be improved.

Note that, in each of the contact parts of (a) and (b) of Fig. 2, Fig. 3, (a) and (b) of Fig. 5, Fig. 7, and (a) and (b) of Fig. 8, (i) a pattern in which the gate electrode Tr4g is electrically connected to the connection line 31 and (ii) a pattern in which the capacitor electrode CAPm is electrically connected to the gate electrode Tr4g, are not separated from each other but are combined with each other. Such two electrical connections are thus realized. That is, one of (i) an electric connection between the connection line 31 and the gate electrode Tr4g and (ii) an electric connection between the capacitor electrode CAPm and the gate electrode Tr4g, is an indirect electric connection via the other electric connection made by a direct contact.

The gate electrode Tr4g is provided in a layer closer to a glass substrate (substrate) 35 than the source electrode Tr4s and the drain electrode Tr4d (a source metal layer and a drain metal layer). Therefore, the gate electrode Tr4g, the connection line 31 (a source metal layer and a drain metal layer), the capacitor electrode CAPm are provided, in this order, above the glass substrate (substrate) 35. Conventionally, a contact of the connection line 31 with the gate electrode Tr4g located lower than the connection line 31, has been made with respect to the gate electrode Tr4g. Therefore, in a case where (i) the capacitor electrode CAPm is further electrically connected to the gate electrode Tr4g (ii) a pattern is prepared which causes the capacitor electrode CAPm to be subjected to direct contact to the gate electrode Tr4g, a contact process is carried out in which the capacitor electrode CAPm is headed to the gate electrode Tr4g after a contact process is carried out in which the connection line 31 is headed to the gate electrode Tr4g. In this case, in order to carry out positioning of the two contact patterns, it is necessary to prepare a large contact pad by taking into consideration a large dimension margin for the gate electrode Tr4g.

Instead of conventional additional contact from the capacitor electrode CAPm to the gate electrode Tr4g, (i) a contact from the capacitor electrode CAPm to the gate electrode Tr4g and (ii) a contact from the capacitor electrode CAPm to the connection line 31 can be simultaneously made during pattering of the capacitor electrode CAPm, in, for example, (a) and (b) of Fig. 2, by employing the one of the electric connections as the indirect electric connection via the other of the electric connections made by the direct contact. The capacitor electrode CAPm is electrically connected to the gate electrode Tr4g by a direct contact of the capacitor electrode CAPm with the gate electrode Tr4g. The gate electrode Tr4g is electrically connected to the connection line 31 indirectly via the direct contact of the capacitor electrode CAPm with the gate electrode Tr4g. The contact hole 33a is secured for bringing the capacitor electrode CAPm into contact with the gate electrode Tr4g and the connection line 31, simultaneously.

Note that the number of masks necessary for forming a contact part is one in (a) and (b) of Fig. 2, two in (a) and (b) of Fig. 5, one in Fig, 7, and two in (b) of Fig. 8.

In (a) and (b) of Fig. 5, the gate electrode Tr4g, the connection line 31, and the capacitor electrode CAPm can be brought, in this order, into contact with each other in a contact hole. Therefore, a pattern is simple, and a process is very simplified. Furthermore, a whole contact pattern area can be reduced.

In Fig. 7, it is possible to bring the capacitor electrode CAPm (top layer) into contact with the gate electrode Tr4g and the connection line 31, simultaneously. Therefore, merely one mask is needed, there are not many restrictions in dimension of a pattern, and a process is simplified, although two contact holes are formed in different places.

In (a) and (b) of Fig. 8, the connection line 31 is brought into contact with the gate electrode Tr4g, and then merely a shallow contact hole is formed so as to bring the capacitor electrode CAPm into contact with the connection line 31. This causes two contact holes to be formed in different places but a process is simplified.

The contact parts of (a) and (b) of Fig. 2, Fig. 3, (a) and (b) of Fig. 5, Fig. 7, and (a) and (b) of Fig. 8 can easily reduce respective occupied areas. Furthermore, the number of processes each for making contact is reduced. Therefore, the substantial number of line connection regions is reduced and a process defect is unlikely to occur.

In the contact part illustrated in (a) and (b) of Fig. 5, (i) a first region where the capacitor electrode CAPm and the connection line 31 are electrically connected with each other and (ii) a second region where the gate electrode Tr4g and the connection line 31 are electrically connected, overlap each other in the film thickness direction. Since the first region and the second region are thus formed so as to overlap or substantially overlap each other in the film thickness direction, it is possible to remarkably reduce patterns of the contact parts. In each of the contact parts illustrated in (a) and (b) of Fig. 2, Fig. 3, Fig. 7, and (a) and (b) of Fig. 8, two of the capacitor electrode CAPm, the gate electrode Tr4g, and the connection line 31 are electrically connected to respective different regions of the other one of the capacitor electrode CAPm, the gate electrode Tr4g, and the connection line 31 in the film thickness direction. The first region and the second region are formed so as to be separate from each other in the film thickness direction. This causes contact holes to be individually formed. Since it is possible to reduce an electric disconnection or a high resistance caused by a step, a stable contact resistance can be obtained.

Note that examples of a first transistor, which is subjected to formation of an additional capacitor such as the capacitor CAP described with reference to Figs. 1 through 8, encompass a transistor, such as the transistor Tr1 or Tr3 illustrated in (a) of Fig. 13, which (i) has a source electrode or a drain electrode that is connected to a node netA that serves as a control electrode of an output transistor and (ii) is different from the output transistor. Note also that a capacitor electrode can be connected anywhere other than to the source electrode or the drain electrode, the capacitor electrode and the source electrode or the drain electrode, which make a pair, forming the additional capacitor.

Note that it is assumed in the above descriptions discussing with reference to Figs. 1 through 8 that the first transistor is an output transistor Tr10 of a shift register stage (see (a) of Fig. 14). According to the assumption, a capacitor electrode CAPm is electrically connected to a node netA that serves as a control electrode of the output transistor Tr10. The node netA is located so that a metal layer to be used can be switched. For example, the node netA is located so that the node netA is electrically connected to a source electrode or a drain electrode of a transistor Tr11 of a shift register stage different from the output transistor Tr10. Therefore, the node netA can be directly connected to a gate of the output transistor Tr10 but is not limited to such a connection. The capacitor electrode CAPm can be directly connected to the node netA but is not limited to such a connection.

The first transistor can be a transistor Tr21 of a shift register stage, which transistor Tr21 is different from an output transistor Tr20 of a shift register stage (see (b) of Fig. 14). In (b) of Fig. 14, a capacitor electrode CAPm is electrically connected to a node netA, and a capacitor is formed by the capacitor electrode CAPm and a source electrode or a drain electrode of the transistor Tr21.

The first transistor can be a transistor Tr31 of a shift register stage, which transistor Tr31 is different from an output transistor Tr30 of a shift register stage. A source electrode or a drain electrode of the transistor Tr31 can be electrically connected to a node netA. Therefore, a capacitor can be formed by a capacitor electrode CAPm and the node netA, that is, the source electrode or the drain electrode of the transistor Tr31 (see (c) of Fig. 14).

Fig. 9 illustrates a configuration of another embodiment of a pattern layout of the transistor Tr4 and the capacitor CAP.

Fig. 9 shows that a capacitor such as the capacitor CAP is added to a transistor Tr4 by configuring (i) a first line via which a first electrode of the transistor Tr4 is connected to a first different element and (ii) a second line via which a second electrode of the transistor Tr4 is connected to a second different element so as to face each other in a film thickness direction. Each of the first electrode and the second electrode can be selected from a gate electrode, a source electrode, or a drain electrode of the transistor Tr4 in accordance with a place where the capacitor is to be additionally formed. Different metal layers are employed as the respective first and second lines. For example, a gate metal is employed as one of the first and second lines, whereas a source metal is employed as the other.

In a case where the capacitor CAP is added to the transistor Tr4, (i) a connection line 31 serving as, for example, the first line via which, for example, the gate electrode of the transistor Tr4 is connected to a first different TFT element and (ii) a connection line 43 serving as, for example, the second line via which, for example, the source electrode of the transistor Tr4 is connected to a second different TFT element, are configured so as to face each other in the film thickness direction.

According to the configuration of Fig. 9, it is possible to add a capacitor to an output transistor, by configuring existing different line regions so as to face each other.

This allows a capacitor to be added to an output transistor by use of existing line regions, in a case where the capacitor is formed by arbitrary electrodes of the output transistor. In this configuration, it is not necessary to separately secure a region, where the capacitor is to be formed, away from an active region of an output transistor in an in-plane direction of a panel, unlike a conventional configuration. It is therefore possible to make small a frame region. It is further possible to employ a metal layer of lines, as they are, in order to add the capacitor. This makes it possible to form a pattern by use of a photomask for use in processing of the metal layer. As such, (i) a process is not complicated and (ii) it is not necessary to separately add a material for capacitor electrodes.

The following description will discuss a configuration of yet another embodiment of a pattern layout of the transistor Tr4 and the capacitor CAP.

Fig. 10 is a perspective view illustrating an arrangement of a capacitor CAP and a gate electrode Tr4 in the vicinity of a contact part which is a part of the pattern layout.

In Fig. 10, a connection line (third line) 45 is arranged, between (a) a gate metal layer Trg connected to a source electrode that is one of a source electrode and a drain electrode of a transistor Tr of a shift register stage SRk and (b) a capacitor electrode (first electrode) CAPm" connected to the gate metal layer Trg, so as to partially facing the gate metal layer Trg and the capacitor electrode CAPm" in a film thickness direction. The connection line 45 is (i) electrically connected to a node netA that serves as a control electrode of the transistor (first transistor) Tr4 and (ii) formed by use of a source electrode layer or a drain electrode layer. In Fig. 10, the gate metal layer Trg is connected to a gate bus line GL.

According to Patent Literature 1, a control electrode 125 of an output transistor is connected to an auxiliary electrode 83 (see Fig. 17). This causes a liquid crystal layer to contact an upper surface of a pixel electrode layer 103 (corresponding to the auxiliary electrode 83) that is a top layer (see Fig. 18). Such a configuration causes electric field noise, which is caused by display driving, to be propagated from a liquid crystal layer side toward the control electrode (corresponding to a node netA illustrated in (a) of Fig. 12) of the output transistor via the pixel electrode layer 103. Therefore, a malfunction can occur in the output transistor.

Meanwhile, according to the configuration of Fig. 10, the third line is further provided between the gate metal layer and the first electrode. This allows additions of (i) a capacitor formed by the third line and the gate metal layer and (ii) a capacitor formed by the third line and the first electrode. Therefore, noise is unlikely to be propagated to the node netA from a liquid crystal layer LC that is brought into contact with the upper surface of the capacitor electrode CAPm" unless the noise passes through (i) a capacitor Cf1 formed by the connection line 31 and the capacitor electrode CAPm" and (ii) a capacitor Cf2 formed by the connection line 31 and the gate metal layer Trg. The capacitor electrode CAPm" and the gate metal layer Trg each have an effect of shielding the connection line 45. Furthermore, the capacitors Cf1 and Cf2 and element constants of the connection line 31, the capacitor electrode CAPm", and the gate metal layer Trg can constitute a filter. Therefore, noise is extremely unlikely to be propagated by configuring the capacitors Cf1 and Cf2 so as to shield the connection line 45 and constitute a filter for a noise frequency.

The configuration of Fig. 10 causes an electric potential of the control electrode of the output transistor to be stabilized. It is therefore possible to (i) properly drive the output transistor and (ii) prevent a malfunction from occurring in a shift register stage.

According to the configuration of Fig. 10, it is further possible to reduce a capacitance caused by the control electrode necessary for preventing the malfunction from occurring in the shift register stage. This causes a reduction in surface area of a shift register. Such a reduction in the surface area of the shift register makes it possible to provide a display device whose frame region is made small.

Note, in the configuration of Fig. 10, that, instead of the output transistor, a transistor which is different from the output transistor can be employed as the first transistor.

A shift register of the present invention is configured to be a shift register provided on a substrate, including: a plurality of shift register stages which are connected in cascade, each of the plurality of shift register stages including a first transistor having a capacitor electrode that faces, in a film thickness direction, at least one of source and drain electrodes in a side opposite to a gate electrode, one of (i) the capacitor electrode and (ii) one of the source and drain electrodes which faces the capacitor electrode, being electrically connected to a control electrode of an output transistor of the each of the plurality of shift register stages.

The shift register of the present invention can be configured such that (i) the capacitor electrode is electrically connected to the control electrode, and the first transistor is the output transistor, (ii) the capacitor electrode is electrically connected to the control electrode, and the first transistor is a transistor other than the output transistor, or (iii) the one of the source and drain electrodes which faces the capacitor electrode is electrically connected to the control electrode, and the first transistor is a transistor other than the output transistor.

According to the present invention, in a case where a capacitor is formed for at least the one of the source and drain electrodes of the first transistor, it is not necessary to separately secure a region, where the capacitor is to be formed, away from an active region of a transistor in an in-plane direction of a panel, unlike a conventional configuration. The capacitor can be added in a region that substantially faces the active region in the film thickness direction. Therefore, a frame region can be made small.

It is thus possible to provide a shift register in which a surface area of a capacitor to be connected to a transistor of a shift register stage is reduced.

The following effect can be brought about in a case where the first transistor is the output transistor of the shift register stage. That is, a sufficient bootstrap capacitor can be formed, and the shift register stage can be stably driven. Further, in a case where a capacitor, such as a bootstrap capacitor, is added by the gate electrode of the first transistor and at least one of the source and drain electrodes of the first transistor, it is not necessary to separately secure a region, where the capacitor is to be formed, away from an active region of a transistor in an in-plane direction of a panel from, unlike the conventional configuration. The capacitor can be added in a region that substantially faces the active region in the film thickness direction.

The shift register of the present invention is configured such that each of the source and drain electrodes has (i) a first part arranged in an active region of the first transistor and (ii) a second part which is (a) arranged in a region other than the active region and (b) connected to the first part, and the capacitor electrode faces, in the film thickness direction, (i) the first part and the second part of one of the source and drain electrodes and (ii) the first part of the other of the source and drain electrodes, whereas the capacitor electrode does not face the second part of the other of the source and drain electrodes in the film thickness direction.

According to the present invention, it is possible to make a capacitor between the capacitor electrode and one of the source and drain electrodes greater than that between the capacitor electrode and the other of the source and drain electrodes.

The shift register of the present invention is configured such that the capacitor electrode faces only one of the source and drain electrodes in the film thickness direction.

According to the present invention, it is possible to form a capacitor between the capacitor electrode and one of the source and drain electrodes of the first transistor.

The shift register of the present invention is configured such that the capacitor electrode does not face a semiconductor layer arranged in an active region other than a region that faces, in the film thickness direction, the source and drain electrodes of the first transistor.

According to the present invention, it is possible to form a capacitor whose size changes less and which has a stable and large capacitor, even in a case where the capacitor electrode is misaligned with respect to the source and drain electrodes during production.

The shift register of the present invention is configured such that the capacitor electrode faces a semiconductor layer arranged in an active region other than a region that faces, in the film thickness direction, the source and drain electrodes of the first transistor.

According to the present invention, the capacitor electrode and the source and drain electrodes overlap each other in a large area. This makes it possible to more efficiently secure a large capacitor.

The shift register of the present invention is configured such that the gate electrode of the first transistor is arranged closer to the substrate than the source and drain electrodes, one of (i) a first electric connection between (a) a connection line arranged more distant from the substrate than the gate electrode, with which connection line the gate electrode is connected to another element and (b) the gate electrode and (ii) a second electric connection between the capacitor electrode and the gate electrode, is an indirect electric connection via the other of the first and second electric connections, the other electric connection being made by a direct contact.

According to the present invention, (i) a pattern in which the gate electrode is electrically connected to the connection line and (ii) a pattern in which the capacitor electrode is electrically connected to the gate electrode, are not separated from each other but are combined with each other. Such two electrical connections are thus realized. It is therefore possible to easily reduce an occupied area. Further, the number of processes each for making contacts is reduced. Therefore, the substantial number of line connection regions is reduced, and a process defect is unlikely to occur.

The shift register of the present invention is configured such that a region of the first electric connection and a region of the second electric connection overlap each other in the film thickness direction.

According to the present invention, the region of the first electric connection and the region of the second electric connection overlap or substantially overlap each other. This makes it possible to remarkably reduce patterns of the regions.

The shift register of the present invention is configured such that two of the capacitor electrode, the gate electrode, and the connection line are electrically connected to respective different regions of the other one of the capacitor electrode, the gate electrode, and the connection line in the film thickness direction.

According to the present invention, two contacts are made, and electrical connections in the respective two contacts are individually formed. Therefore, contact holes can be individually formed. Since it is possible to reduce an electric disconnection or a high resistance caused by a step, a stable contact resistance can be obtained.

A display device of the present invention is configured to include the shift register, and the display device employs, for display driving, output signals from the plurality of shift register stages.

According to the present invention, it is possible to attain a display device whose frame region is made small by making small the surface area of the shift register.

The display device of the present invention is configured such that a pixel electrode layer employed in a display region is employed as the capacitor electrode.

According to the present invention, it is possible to employ, as a capacitor electrode, a pixel electrode layer on the active region of the first transistor as it is, which pixel electrode layer has been conventionally removed because it is of no other uses. This makes it possible to form a pattern by use of a photomask for use in processing of a pixel electrode layer. As such, it is possible to prevent a process from being complicated, and it is not necessary to separately use a material for a capacitor electrode.

A display device of the present invention is configured to include selection elements of respective pixels, an insulating film between the capacitor electrode and the respective source and drain electrodes having a thickness smaller than that of an insulating film between the pixel electrode layer of the display region and a source and drain metal layer of a corresponding one of the selection elements.

According to the present invention, it is possible to reduce a thickness of an insulating film between the capacitor electrode and the respective source and drain electrodes, which thickness is set to be thick so as to reduce a paracitic capacitor between a pixel electrode and a signal line in the display region. This makes it possible to increase a capacitor between the capacitor electrode and the respective source and drain electrodes.

A shift register of the present invention is configured to be a shift register provided on a substrate, including: a plurality of shift register stages which are connected in cascade, each of the plurality of shift register stages including a first transistor, the first transistor being provided so that a first line and a second line face each other in a film thickness direction, one of a gate electrode, a source electrode, and a drain electrode of the first transistor being connected to a first element via the first line, another one of the gate electrode, the source electrode, and the drain electrode of the first transistor being connected to a second element which is different from the first element, a first metal layer being employed as the first line, and a second metal layer, which is different from the first metal layer, being employed as the second line.

According to the present invention, it is possible to add a capacitor to the first transistor by arranging existing different line regions so as to face each other.

This allows a capacitor to be added to the first transistor by use of existing line regions, in a case where the capacitor is formed by arbitrary electrodes of the first transistor. In this configuration, it is not necessary to separately secure a region, where the capacitor is to be formed, away from an active region of a transistor in an in-plane direction of a panel, unlike a conventional configuration. It is therefore possible to make small a frame region.

It is thus possible to provide a shift register in which a surface area of a capacitor to be connected to a transistor of a shift register stage is reduced.

In a case where the first transistor is the output transistor of the shift register stage, it is possible to form a sufficient bootstrap capacitor, and to stably drive the shift register stage.

It is further possible to employ a metal layer of a line as it is for newly forming the capacitor. This makes it possible to form a pattern by use of a photomask for use in processing of the metal layer, so that a process is not complicated. This also makes it unnecessary to separately use a material for a capacitor electrode.

A display device of the present invention is configured to include the shift register, and the display device employs, for display driving, output signals from the plurality of shift register stages.

According to the present invention, it is possible to attain a display device whose frame region is made small by making small the surface area of the shift register.

A shift register of the present invention is configured to be a shift register provided on a substrate, including: a plurality of shift register stages which are connected in cascade, a third line formed by use of a source and drain metal layer being electrically connected to a control electrode of an output transistor of a corresponding one of the plurality of shift register stages, the third line being arranged between a gate metal layer and a first electrode which is connected to the gate metal layer so as to have a region that faces the gate metal layer and the first electrode in a film thickness direction.

According to the present invention, it is possible to add capacitors between the third line and the gate metal layer, and between the third line and the first electrode, respectively. The third line is thus arranged between the gate metal layer and the first electrode. Therefore, electric field noise to be propagated to the gate metal layer and the first electrode is unlikely to be propagated to the control electrode of the output transistor via the third line. This makes it possible to reduce a capacitance caused by the control electrode necessary for preventing a malfunction from occurring in the shift register stage. This causes a reduction in surface area of the shift register. Such a reduction in the surface area of the shift register makes it possible to provide a display device whose frame region is made small.

A display device of the present invention is configured to include the shift register, and the display device employs, for display driving, output signals from the plurality of shift register stages.

According to the present invention, it is possible to attain a display device whose frame region is made small by making small the surface area of the shift register.

The display device of the present invention is configured such that the gate metal layer is electrically connected to a scanning signal line to which an output signal from a corresponding one of the plurality of shift register stages is supplied.

According to the present invention, in a case where a bootstrap capacitor is added to the output transistor, it is possible to (i) prevent electric field noise from being propagated from a display element such as a liquid crystal layer to the control electrode of the output transistor via the bootstrap capacitor, and (ii) properly drive the display device.

The present invention is not limited to the description of the embodiments above, and can therefore be modified by a skilled person in the art within the scope of the claims. Namely, an embodiment derived from a proper combination of technical means disclosed in different embodiments is encompassed in the technical scope of the present invention.

### Industrial Applicability

The present invention is suitably applicable to an active matrix display device.

### Reference Signs List

- 1:: shift register
- 11:: liquid crystal display device (display device)
- 12:: display panel
- 12a:: display region
- 21:: TFT (selection element)
- 31:: connection line (first line)
- 35:: glass substrate (substrate)
- 43:: connection line (second line)
- 45:: connection line (third line)
- GL:: gate bus line (scanning signal line)
- SRk:: shift register stage
- Tr4:: transistor (output transistor, first transistor)
- Tr4g:: gate electrode
- Tr4s:: source electrode (first source/ drain electrode)
- Tr4s1:: source finger electrode (first part)
- Tr4s2:: source connection electrode (second part)
- Tr4d:: drain electrode (second source/ drain electrode)
- Tr4d1:: drain finger electrode (first part)
- Tr4d2:: drain connection electrode (second part)
- Tr4c:: contact part
- Tr4c':: contact part
- Tr4c":: contact part
- Tr10:: output transistor (first transistor)
- Tr20:: output transistor
- Tr21:: transistor (first transistor, transistor different from output transistor)
- Tr30:: output transistor
- Tr31:: transistor (first transistor, transistor different from output transistor)
- CAPm:: capacitor electrode
- CAPm':: capacitor electrode
- CAPm":: capacitor electrode (first electrode)
- net A:: node (control electrode)

## Claims

1. A shift register provided on a substrate, comprising:
a plurality of shift register stages which are connected in cascade,
each of the plurality of shift register stages including a first transistor having a capacitor electrode that faces, in a film thickness direction, at least one of source and drain electrodes in a side opposite to a gate electrode,
one of (i) the capacitor electrode and (ii) one of the source and drain electrodes which faces the capacitor electrode, being electrically connected to a control electrode of an output transistor of the each of the plurality of shift register stages.

2. The shift register as set forth in claim 1, wherein:
the capacitor electrode is electrically connected to the control electrode, and
the first transistor is the output transistor.

3. The shift register as set forth in claim 1, wherein:
the capacitor electrode is electrically connected to the control electrode, and
the first transistor is a transistor other than the output transistor.

4. The shift register as set forth in claim 1, wherein:
the one of the source and drain electrodes which faces the capacitor electrode is electrically connected to the control electrode, and
the first transistor is a transistor other than the output transistor.

5. The shift register as set forth in any one of claims 1 through 4, wherein:
each of the source and drain electrodes has (i) a first part arranged in an active region of the first transistor and (ii) a second part which is (a) arranged in a region other than the active region and (b) connected to the first part, and
the capacitor electrode faces, in the film thickness direction, (i) the first part and the second part of one of the source and drain electrodes and (ii) the first part of the other of the source and drain electrodes, whereas the capacitor electrode does not face the second part of the other of the source and drain electrodes in the film thickness direction.

6. The shift register as set forth in any one of claims 1 through 4, wherein:
the capacitor electrode faces only one of the source and drain electrodes in the film thickness direction.

7. The shift register as set forth in claim 6, wherein:
the capacitor electrode does not face a semiconductor layer arranged in an active region other than a region that faces, in the film thickness direction, the source and drain electrodes of the first transistor.

8. The shift register as set forth in claim 6, wherein:
the capacitor electrode faces a semiconductor layer arranged in an active region other than a region that faces, in the film thickness direction, the source and drain electrodes of the first transistor.

9. The shift register as set forth in claim 2, wherein:
the gate electrode of the first transistor is arranged closer to the substrate than the source and drain electrodes,
one of (i) a first electric connection between (a) a connection line arranged more distant from the substrate than the gate electrode, with which connection line the gate electrode is connected to another element and (b) the gate electrode and (ii) a second electric connection between the capacitor electrode and the gate electrode, is an indirect electric connection via the other of the first and second electric connections, the other electric connection being made by a direct contact.

10. The shift register as set forth in claim 9, wherein:
a region of the first electric connection and a region of the second electric connection overlap each other in the film thickness direction.

11. The shift register as set forth in claim 9, wherein:
two of the capacitor electrode, the gate electrode, and the connection line are electrically connected to respective different regions of the other one of the capacitor electrode, the gate electrode, and the connection line in the film thickness direction.

12. A display device comprising a shift register recited in any one of claims 1 through 11,
wherein the display device employs, for display driving, output signals from the plurality of shift register stages.

13. The display device as set forth in claim 12, wherein:
a pixel electrode layer employed in a display region is employed as the capacitor electrode.

14. A display device as set forth in claim 13, comprising selection elements of respective pixels,
an insulating film between the capacitor electrode and the respective source and drain electrodes having a thickness smaller than that of an insulating film between the pixel electrode layer of the display region and a source and drain metal layer of a corresponding one of the selection elements.

15. A shift register provided on a substrate, comprising:
a plurality of shift register stages which are connected in cascade,
each of the plurality of shift register stages including a first transistor,
the first transistor being provided so that a first line and a second line face each other in a film thickness direction, one of a gate electrode, a source electrode, and a drain electrode of the first transistor being connected to a first element via the first line, another one of the gate electrode, the source electrode, and the drain electrode of the first transistor being connected to a second element which is different from the first element,
a first metal layer being employed as the first line, and a second metal layer, which is different from the first metal layer, being employed as the second line.

16. A display device, comprising a shift register recited in claim 15,
wherein the display device employs, for display driving, output signals from the plurality of shift register stages.

17. A shift register provided on a substrate, comprising:
a plurality of shift register stages which are connected in cascade,
a third line formed by use of a source and drain metal layer being electrically connected to a control electrode of an output transistor of a corresponding one of the plurality of shift register stages,
the third line being arranged between a gate metal layer and a first electrode which is connected to the gate metal layer so as to have a region that faces the gate metal layer and the first electrode in a film thickness direction.

18. A display device comprising a shift register recited in claim 17,
wherein the display device employs, for display driving, output signals from the plurality of shift register stages.

19. The display device as set forth in claim 18, wherein:
the gate metal layer is electrically connected to a scanning signal line to which an output signal from a corresponding one of the plurality of shift register stages is supplied.
